# FASCICULE DE BREVET EUROPEEN

(11) **EP 1 005 083 B1**
(45) Date de publication et mention de la délivrance du brevet: **14.07.2004**
(21) Numéro de dépôt: 99402890.0
(22) Date de dépôt: 22.11.1999
(51) Int. Cl.: H01L 23/473

(54) **Composant électronique de puissance comportant des moyens de refroidissement**
Elektronisches Leistungselement mit Kühlvorrichtung
High-power electronic device comprising cooling system

(30) Priorité: 27.11.1998 FR 9815155
(43) Date de publication de la demande: 31.05.2000
(73) Titulaire: Alstom Holdings, 75116 Paris (FR)
(72) Inventeur: Mermet-Guyennet, Michel, 65 390 Aurensan (FR); Schaeffer, Christian, 38 730 Le Pin (FR)
(74) Mandataire: de Lambilly Delorme, Marie Pierre

(56) Documents cités:
- EP-A- 0 871 352
- DE-A- 4 311 839
- FR-A- 2 737 608
- KAZUO TSUBOUCHI ET AL: "THEORETICAL ANALYSIS FOR A NEW PACKAGE CONCEPT: HIGH-SPEED HEAT REMOVAL FOR VLSI USING AN AIN HEAT-SPREADING LAYER AND MICROCHANNEL FIN" , JAPANESE JOURNAL OF APPLIED PHYSICS, VOL. 30, NR. 1B, PAGE(S) L88 - L91 XP000223790 ISSN: 0021-4922 * le document en entier *
- DATABASE INSPEC [Online] INSTITUTE OF ELECTRICAL ENGINEERS, STEVENAGE, GB PERRET C ET AL: "Microchannel integrated heat sinks in silicon technology" Database accession no. 6161880 XP002108745 & CONFERENCE RECORD OF 1998 IEEE INDUSTRY APPLICATIONS CONFERENCE. THIRTY-THIRD IAS ANNUAL MEETING (CAT. NO.98CH36242), CONFERENCE RECORD OF 1998 IEEE INDUSTRY APPLICATIONS CONFERENCE. THIRTY-THIRD IAS ANNUAL MEETING, ST. LOUIS, MO, USA, 12-15 OCT. 199, pages 1051-1055 vol.2, 1998, New York, NY, USA, IEEE, USA ISBN: 0-7803-4943-1

## Description

La présente invention concerne un composant électronique de puissance.

De manière habituelle, les composants électroniques de puissance, qui sont en particulier utilisés pour réaliser des onduleurs destinés à la traction ferroviaire, comprennent une semelle réalisée par exemple en cuivre. Une multiplicité de structures composites de type conducteur-isolant-conducteur qui assument à la fois une fonction de transfert thermique et d'isolation électrique, sont rapportées sur cette semelle. Elles sont par exemple réalisées sous la forme d'un empilement cuivre-céramique-cuivre encore dénommé Direct Bonded Copper (DBC). Ces structures composites peuvent également être exécutées sous forme de substrats métalliques isolés (SMI) qui comprennent une couche inférieure en aluminium ou en cuivre, une couche intermédiaire en époxy et une couche supérieure en cuivre éventuellement réalisée en plusieurs parties.

La demande de brevet DE-A-4 311 839 mentionne des structures en silicium pour le transport thermique comprenant des moyens de passage d'un fluide caloporteur et la demande de brevet EP-A-0 871 352 mentionne une structure de transport thermique pour des composants électroniques.

Sur chaque structure composite sont disposés plusieurs circuits semi-conducteurs de puissance, qui sont par exemple des transistors bipolaires à grille isolée dits IGBT, ou bien encore des diodes. Ces circuits semi-conducteurs sont en outre recouverts sur une de leurs faces par des plots de connexion, et sont assujettis à la couche métallique libre de la structure composite par leur face exempte de plots. Ces circuits y sont fixés par exemple par soudure tendre d'étain-plomb ou encore d'étain-plomb-argent.

Puis on soude, sur chaque plot de connexion, plusieurs fils d'aluminium présentant typiquement un diamètre de 380 à 500 microns. Chacun de ces fils est également soudé sur la couche métallique supérieure de la structure composite. Cet ensemble formé par la semelle, les structures composites et les circuits semi-conducteurs de puissance, est ensuite disposé dans un boîtier rempli de gel silicone et recouvert d'un capot en résine époxy, de manière à former un composant électronique de puissance.

Ce dernier est disposé, de manière habituelle, sur un élément de refroidissement qui peut être une plaque à eau, un échangeur de chaleur à air ou encore une base d'évaporateur "caloduc". Un tel élément est destiné à maintenir la température à laquelle est soumis le composant électronique de puissance à une valeur inférieure à 125°C, de manière à en conserver l'intégrité.

De façon générale, le problème du refroidissement est tout particulièrement crucial dans le domaine des composants électroniques de puissance, dans la mesure où c'est cette température seuil d'environ 125°C qui détermine la valeur du courant admissible par le composant.

En particulier, si l'on désire augmenter la capacité nominale en courant de tels composants, il est nécessaire d'augmenter la quantité de matériau semi-conducteur utilisé, ce qui induit bien évidemment une augmentation du prix de revient.

L'invention a donc pour but d'améliorer le refroidissement des composants électroniques de puissance, de manière soit à augmenter la tenue en courant de ces composants pour un volume et donc un prix de revient donnés, soit à en diminuer, pour un courant nominal donné, le volume et donc le prix de revient.

L'invention se propose plus particulièrement de réaliser un composant électronique de puissance dont la structure globale soit différente de celle des composants de l'art antérieur, et permette de ce fait d'en améliorer le refroidissement.

A cet effet, l'invention a pour objet un composant électronique de puissance comprenant une première structure composite de transfert thermique et d'isolation électrique, supportant au moins un circuit semi-conducteur de puissance dont la face opposée à ladite première structure composite est pourvue de plots de connexion, ladite première structure composite comportant deux couches conductrices ou semi-conductrices respectivement adjacente et opposée audit circuit semi-conducteur , caractérisé en ce que lesdits plots de connexion sont assujettis, par leur face opposée à ladite première structure composite, à un réseau plan d'éléments conducteurs isolés entre eux, ledit réseau étant intégré à au moins une deuxième structure composite de transfert thermique et d'isolation électrique, qui comporte une couche conductrice ou semi-conductrice opposée audit circuit semi-conducteur, et en ce que la couche opposée d'au moins l'une des première ou deuxième structure composite comprend des moyens de passage d'un fluide caloporteur.

Selon d'autres caractéristiques de l'invention :
- la couche opposée au circuit semi-conducteur est réalisée en matériau semi-conducteur, notamment en silicium ;
- la couche semi-conductrice opposée au circuit semi-conducteur comprend des première et deuxième plaquettes assemblées l'une à l'autre, au moins l'une des plaquettes étant pourvue de gorges, et les moyens de passage du fluide caloporteur comprennent des canaux traversants ménagés dans ladite couche opposée au circuit semi-conducteur, ces canaux étant réalisés par coopération de formes entre les plaquettes ;
- les plaquettes sont pourvues de séries de gorges respectives et les canaux sont réalisés de part et d'autre du plan de joint des deux plaquettes, par coopération de forme entre lesdites gorges en regard ;
- les canaux ont une section transversale de forme hexagonale ;
- la couche opposée au circuit semi-conducteur est réalisée en matériau métallique ;
- les moyens de passage du fluide caloporteur débouchent sur la face distale de la couche métallique opposée au circuit semi-conducteur de puissance ;
- les moyens de passage comprennent au moins un canal s'étendant sur au moins une partie d'au moins une dimension de la couche conductrice opposée au circuit semi-conducteur ;
- les plots sont assujettis au réseau plan adjacente de la deuxième structure composite par soudure d'au moins un bossage d'étain-plomb-argent et
- les plots sont séparés du ou de chaque bossage par un revêtement adhérent au ou à chaque bossage, notamment un dépôt de titane-nickel-or.

L'invention va être décrite ci-dessous, en référence aux dessins annexés, donnés uniquement à titre d'exemples non limitatifs et dans lesquels :
- les figures 1 à 3 sont des vues schématiques illustrant la réalisation d'une couche appartenant à une structure composite incluse dans un composant électronique de puissance conforme à l'invention ;
- la figure 4 est une vue schématique illustrant la structure composite formée à partir de la couche représentée aux figures 1 à 3, structure sur laquelle est disposé un circuit semi-conducteur de puissance ;
- la figure 5 est une vue schématique à plus grande échelle du circuit semi-conducteur de la figure 4 ;
- la figure 6 est une vue schématique illustrant un composant conforme à l'invention, comprenant deux structures composites telles que représentées à la figure 4 ;
- les figures 7 à 9 sont des vues schématiques illustrant une variante de réalisation d'une structure composite d'un composant électronique de puissance selon l'invention, et
- la figure 10 est une vue schématique illustrant un composant selon l'invention, incluant deux structures telles que représentées aux figures 8 et 9.

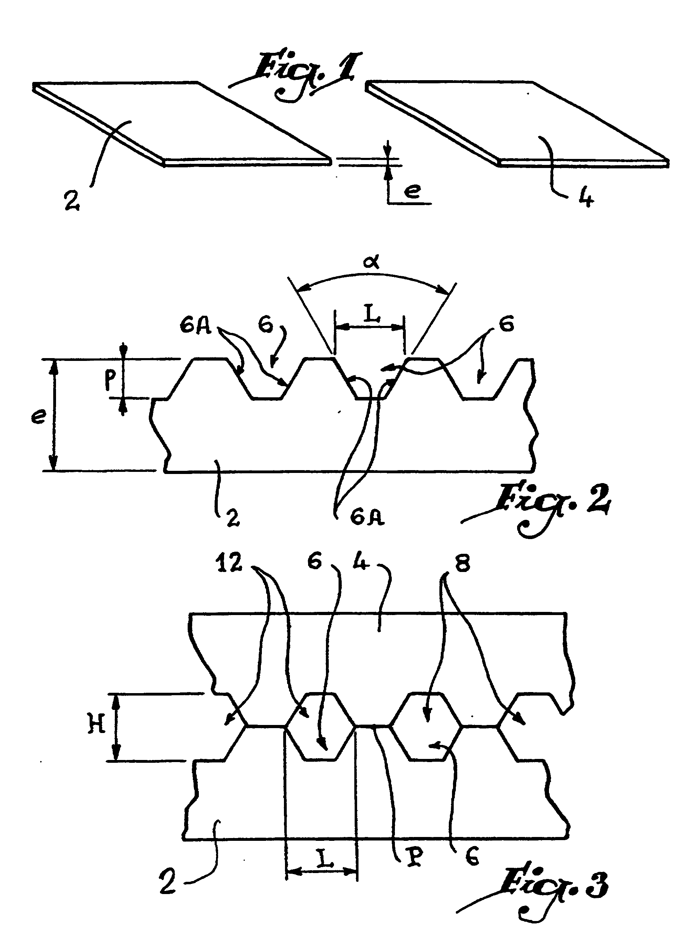

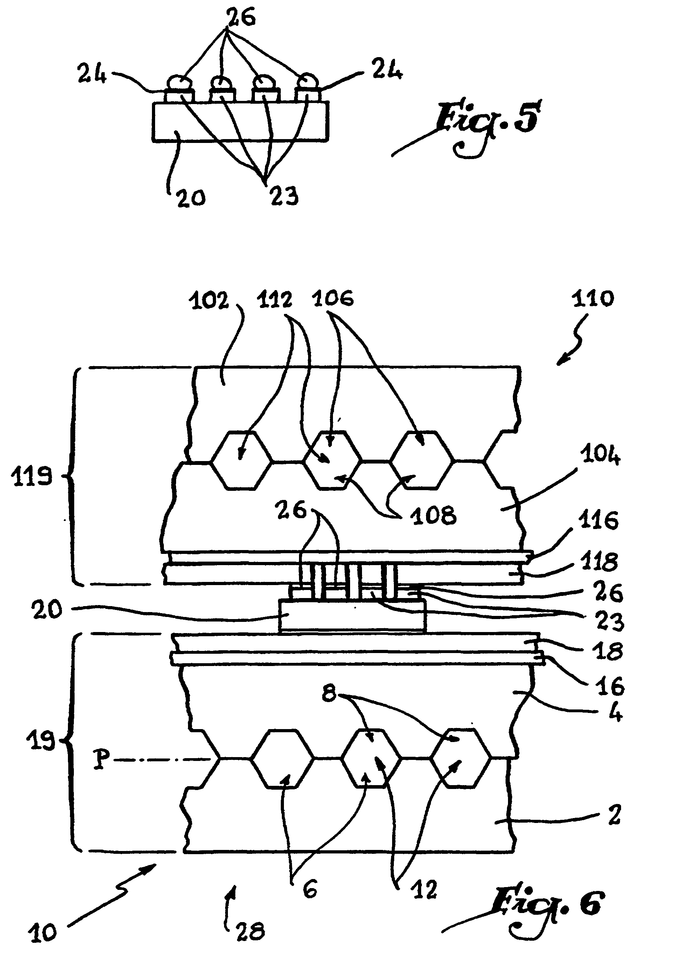

Les figures 1 à 3 illustrent la fabrication d'une couche semi-conductrice destinée à être intégrée dans un composant électronique de puissance selon l'invention. Cette fabrication fait tout d'abord appel à deux plaquettes représentées à la figure 1 et appelées par convention première plaquette 2 et deuxième plaquette 4, qui sont réalisées en silicium mono-cristallin. Elles présentent des dimensions analogues l'une de l'autre, à savoir qu'elles possèdent une épaisseur e d'environ 1 mm et des dimensions principales d'environ 50 sur 50 mm.

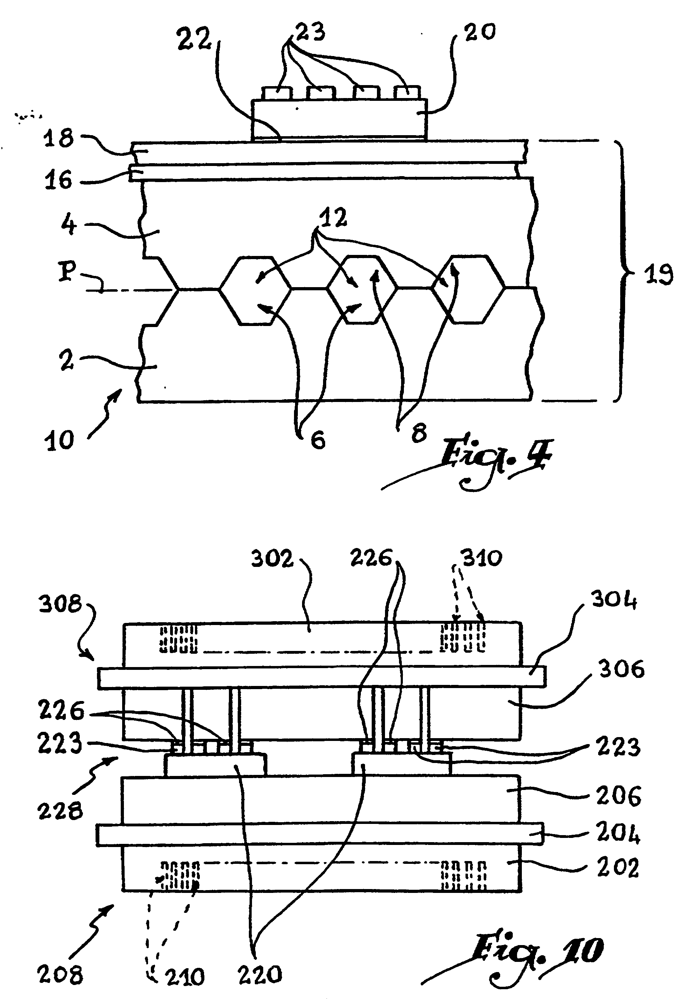

Comme le montre la figure 2, il s'agit ensuite de réaliser des gorges 6 au sein de la première plaquette 2. Ces gorges sont exécutées, de manière connue en soi, par l'intermédiaire d'un procédé de gravure humide par attaque chimique. Etant donné la nature de silicium mono-cristallin, cette opération est particulièrement aisée et conduit à la formation de gorges présentant un profil en U à ailes inclinées, la gravure s'effectuant en suivant les plans cristallins. L'angle α définissant l'inclinaison des ailes 6A des gorges est voisin de 57°. On réalise ces gorges parallèlement à l'une des directions principales de la plaquette, entre deux bords opposés.

L'opération de gravure est arrêtée lorsque la profondeur p de la gorge 6 est égale à environ la moitié de sa largeur L. Dans l'exemple de réalisation considéré, on exécute, sur la plaquette 2, environ 50 gorges, ce qui correspond à une densité d'environ 10 gorges par cm. Les gorges 6 peuvent également présenter une forme de V.

La figure 2 illustre uniquement la réalisation des gorges 6 au niveau de la plaquette 2, étant entendu que dans le mode d'exécution décrit, on réalise au niveau de la deuxième plaquette 4 des gorges analogues qui seront désignées par la référence 8 dans ce qui suit.

Il s'agit ensuite d'asssembler mutuellement les deux plaquettes 2 et 4. A cet effet, on dispose les séries de gorges respectives 6, 8 en regard les unes des autres, puis on assujettit de manière connue les deux plaquettes par soudage. Cette opération est réalisée à une température d'environ 600°C.

La couche formée par l'assemblage des deux plaquettes 2 et 4 est désignée dans son ensemble par la référence 10. Elle est pourvue d'une multiplicité de canaux 12 réalisés par coopération de formes des gorges 6 et 8 en regard, qui sont ménagées dans les plaquettes respectives 2 et 4. Ces canaux 12 s'étendent de part et d'autre du plan de joint P entre les deux plaquettes 2, 4, présentent une forme sensiblement hexagonale et possèdent une largeur L sensiblement égale à leur hauteur H. Ces canaux sont débouchants, ou traversants, à savoir qu'ils s'étendent entre deux chants opposés de la couche 10.

Dans le présent exemple, des gorges sont réalisées au sein des deux plaquettes 2 et 4. On peut également prévoir d'exécuter de telles gorges sur une seule plaquette, les canaux étant formés par ces gorges et la surface plane de l'autre plaquette.

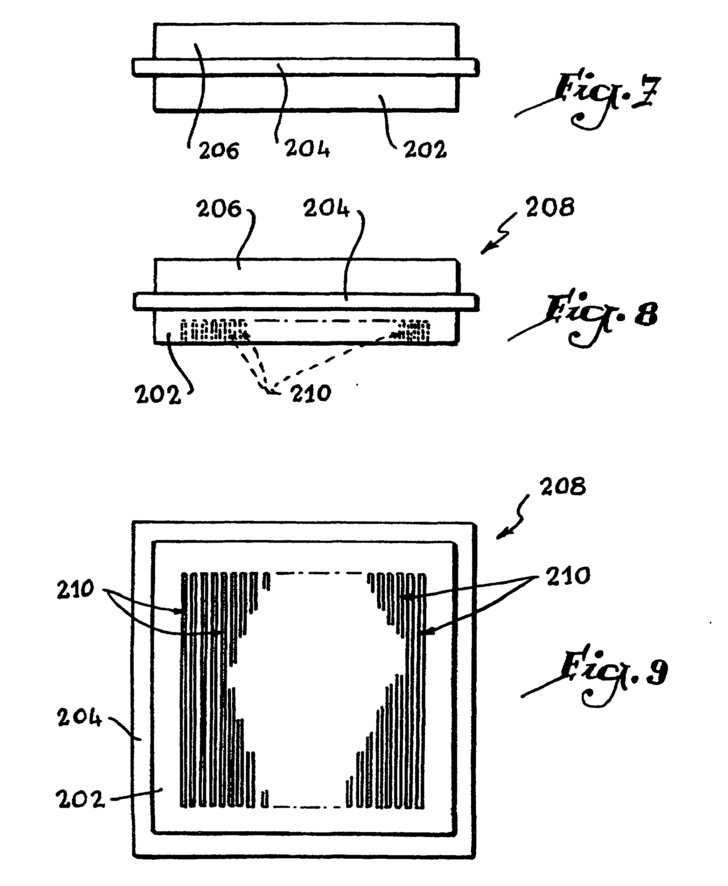

Comme le montre la figure 4, on rapporte ensuite, au-dessus de la couche 10, une couche isolante 16 en silice, sur laquelle est disposée une couche supplémentaire 18 de silicium mono-cristallin, de manière à former une structure composite 19. La réalisation de cette structure 19 incluant les couches 10, 16 et 18, s'effectue de manière classique, par des procédés de dépôts couches minces et électrolytiques utilisés de manière classique dans l'électronique.

Un circuit semi-conducteur de puissance 20, tel qu'un IGBT ou une diode, est assujetti de manière classique sur la face libre de la couche 18, au moyen d'une couche de soudure 22 d'étain-plomb. Il est à noter que, contrairement aux composants électroniques de puissance classiques, les plots 23 du circuit 20 ne sont pas reliés à la couche 18 au moyen de fils d'aluminium.

La figure 5 illustre une phase suivante de réalisation d'un composant électronique de puissance conforme à l'invention, phase qui consiste tout d'abord à revêtir la face libre des plots 23 au moyen d'un multicouche 24 de titane-nickel-or dont l'épaisseur est d'environ 0,8 micromètres et qui est déposé par exemple au moyen d'un procédé de pulvérisation.

Sur ce multicouche 24, on dispose un bossage 26 réalisé en étain-plomb-argent, dont la taille correspond à celle du plot 12. Dans l'exemple considéré, ce bossage a une composition d'environ 2 % d'étain, de 95,5 % de plomb et de 2,5% d'argent. Il est à noter que la présence du multicouche 24 confère une excellente tenue mécanique du bossage 26 sur le plot 23.

Il s'agit ensuite de réaliser une deuxième structure composite désignée dans son ensemble par la référence 119, destinéer à assumer une fonction de transfert thermique et d'isolation électrique.

Cette structure 119 comprend des couches 110 et 116 identiques à celles 10 et 16 de la structure 19. La couche 116 est recouverte par un réseau plan 118 d'éléments conducteurs isolés entre eux, dont la configuration est adaptée à celle du circuit semi-conducteur 20 que ce réseau plan 118 doit recouvrir.

Puis on retourne cette deuxième structure 119 et on met en contact le réseau plan 118 de cette dernière avec chaque bossage 26 disposé sur les plots 23 du circuit semi-conducteur de puissance 20. On opère ensuite une fusion de chaque bossage 26 en le chauffant par exemple à environ 330 °C pendant 10 secondes. Les plots 23 sont alors assujettis au réseau plan 118 de la structure composite 119, réseau 118 qui sera appelé adjacent, par opposition à la couche 110 dénommée opposée.

Le composant électronique de puissance ainsi formé et désigné dans son ensemble par la référence 28, est alors à même d'être refroidi à la fois pour l'intermédiaire des couches 10 et 110. En effet, les canaux 12 et 112 dont ces dernières sont respectivement pourvues sont destinés au passage d'un fluide caloporteur gazeux ou liquide et sont à cet effet mis en relation avec une source d'un tel fluide.

La conformation du composant électronique de puissance 28 de l'invention permet de plus de s'affranchir de la présence des fils d'aluminium dont sont habituellement pourvus les composants de l'art antérieur. En l'espèce, le réseau plan 118 de la deuxième structure composite 119 assume le rôle habituellement dévolu à ces fils d'aluminium.

Les figures 7 à 9 représentent l'exécution d'une autre structure composite destinée à être intégrée dans un composant électronique de puissance conforme à l'invention.

Cette fabrication fait tout d'abord appel à une structure composite de type conducteur-isolant-conducteur dans sa conformation habituelle, représentée à la figure 7. Cette structure comprend une première couche 202, ou couche inférieure réalisée par exemple en cuivre et surmontée par une couche isolante 204 intermédiaire supportant une deuxième couche métallique 206, ou couche supérieure, également en cuivre. Les couches conductrices 202 et 206 présentent par exemple une épaisseur de 3 à 4 mm et des dimensions principales de 48 x 48 mm, alors que la couche isolante 204 possède une épaisseur de 0,635 mm et des dimensions principales de 50 x 50 mm.

Les figures 8 et 9 représentent une structure composite destinée à être intégrée dans un composant conforme à l'invention, structure désignée dans son ensemble par la référence 208 et qui a été réalisée à partir de la stucture représentée à la figure 7. La couche inférieure 202 de cette structure 208 est pourvue d'une multiplicité de canaux ou conduits 210 destinés à constituer des moyens de passage d'un fluide caloporteur. Ces canaux sont réalisés parallèlement à l'une des dimensions principales de la couche inférieure 202, à partir de la face inférieure de cette dernière, comme le montre en particulier la figure 8. Chacun de ces canaux s'étend sur une partie substantielle de l'épaisseur de cette couche inférieure 2, c'est-à-dire par exemple sur une hauteur comprise entre 2 et 3 mm. On peut également prévoir que les canaux 210 s'étendent sur toute l'épaisseur de la couche inférieure 202. La largeur de ces canaux est par exemple de 200 micromètres et leur longueur comprise entre 40 et 50 mm. Dans l'exemple de réalisation décrit, ces canaux 210 sont prévus au nombre d'environ 50, de sorte que deux canaux voisins sont espacés d'une distance comprise entre 200 et 300 micromètres.

Il convient ensuite, comme le montre la figure 8, de disposer sur la face supérieure de la couche 206, deux circuits semi-conducteurs de puissance 220 identiques à celui 20 des figures 4 à 6. On dépose ensuite un bossage d'étain-plomb-argent 226 sur chaque plot 223 de ces circuits semi-conducteurs, de manière analogue à ce qui a été décrit en faisant référence à la figure 5.

Puis, il s'agit de réaliser une deuxième structure composite, désignée dans son ensemble par la référence 308, qui comprend des couches 302 et 304 identiques à celles 202 et 204.

La couche 304 est en outre recouverte par un réseau plan 306 d'éléments conducteurs isolés entre eux, dont la configuration est adaptée à celle du circuit semi-conducteur 220 que ce réseau plan recouvre.

On retourne alors cette structure 308 et on met en contact le réseau plan 306 de cette dernière, avec le bossage 326. Puis on opère une fusion de ce dernier, de manière conforme à ce qui a été décrit en référence à la figure 6.

Les plots 223 sont alors assujettis au réseau plan 306 de la deuxième structure composite 308, réseau 306 qui sera appelée adjacent par opposition à la couche 302 dénommée opposée.

Le composant électronique de puissance ainsi formé, désigné dans son ensemble par la référence 228, est alors à même d'être refroidi à la fois par l'intermédiaire des couches 202, 302 opposées au circuit semi-conducteur 220. En effet, les canaux 210, 310 ménagés dans ces dernières sont propres au passage d'un fluide caloporteur gazeux ou liquide et sont, à cet effet mis en relation avec une source d'un tel fluide.

Dans l'exemple considéré, les canaux débouchent sur la face distale des couches 202 et 302, à savoir leur face la plus éloignée du circuit semi-conducteur 220.

Le composant électronique de puissance conforme à l'invention permet d'atteindre les objectifs précédemment mentionnés. En effet, il permet de s'affranchir de la présence des fils d'aluminium dont sont pourvus les composants de l'art antérieur. Or, ces fils constituent un facteur limitant à l'égard du problème du refroidissement, dans la mesure où ils s'échauffent de manière proportionnelle au carré du courant qui les traverse, et qu'il se révèle difficile de la refroidir puisqu'ils sont noyés dans du gel silicone. De plus, ces fils d'aluminium peuvent être à l'origine de graves dysfonctionnements de l'ensemble du composant électronique de puissance. En effet, ils sont soumis, en service, à des cyclages thermiques, de sorte qu'ils sont à même de se rompre.

Le composant de l'invention, outre qu'il est dépourvu de tels fils d'aluminium, assure un double refroidissement simultané des circuits semi-conducteurs de puissance qui le composent, à la fois depuis leurs faces inférieure et supérieure.

De plus, les structures composites formant le composant conforme à l'invention assument, outre leurs fonctions habituelles de transfert themique et d'isolation électrique, une fonction supplémentaire de refroidissement. Ceci permet donc de limiter le nombre d'interfaces entre les différentes couches constituant le composant de l'invention, puisque l'élement de refroidissement est intégré à chaque structure composite. Ceci a également pour effet d'augmenter le coefficient d'échange convectif avec le fluide caloporteur circulant dans les canaux ménagés dans la couche opposée de chaque structure composite.

Ceci permet, pour un courant nominal donné, d'utiliser un volume de silicium très nettement inférieur à celui nécessaire à la réalisation des composants électroniques de puissance de l'art antérieur. De plus, pour un volume de silicium comparable à celui utilisé dans un composant de l'art antérieur, le composant conforme à l'invention possède une tenue en courant notablement plus élevée.

## Revendications

1. Composant électronique de puissance (28, 228), comprenant une première structure composite (19 ; 208) de transfert thermique et d'isolation électrique, supportant au moins un circuit semi-conducteur de puissance (20 ; 220) dont la face opposée à ladite première structure composite est pourvue de plots de connexion (23 ; 223), ladite première structure composite (19 ; 208) comportant deux couches conductrices ou semi-conductrices respectivement adjacente (18 ; 206) et opposée (10 ; 202) audit circuit semi-conducteur (20 ; 220), dans lequel lesdits plots de connexion (23 ; 223) sont assujettis, par leur face opposée à ladite première structure composite (19 ; 208), à un réseau plan (118 ; 306) d'éléments conducteurs isolés entre eux, ledit réseau étant intégré à au moins une deuxième structure composite (119 ; 308) de transfert thermique et d'isolation électrique, qui comporte une couche conductrice ou semi-conductrice opposée (110 ; 302) audit circuit semi-conducteur, et en ce que la couche opposée (10, 110 ; 202, 302) d'au moins l'une des première (19 ; 208) ou deuxième (119 ; 308) structure composite comprend des moyens de passage (12, 112 ; 210, 310) d'un fluide caloporteur.

2. Composant (28) suivant la revendication 1, **caractérisé en ce que** ladite couche opposée (10, 110) d'au moins l'une des première ou deuxième structure composite est réalisée en matériau semi-conducteur, notamment en silicium.

3. Composant suivant la revendication 2, **caractérisé en ce que** ladite couche semi-conductrice opposée (10, 110) d'au moins l'une des première ou deuxième structure composite comprend des première et deuxième plaquettes (2, 4, 102, 104) assemblées l'une à l'autre, au moins l'une des plaquettes étant pourvue de gorges (6, 8, 106, 108), et **en ce que** les moyens de passage du fluide caloporteur comprennent des canaux traversants (12, 112) ménagés dans ladite couche opposée (10, 110) d'au moins l'une des première ou deuxième structure composite, lesdits canaux étant réalisés par coopération de formes entre lesdites plaquettes (2, 4, 102, 104).

4. Composant suivant la revendication 3, **caractérisé en ce que** lesdites plaquettes sont pourvues de séries de gorges respectives (6, 8) et les canaux (12, 112) sont réalisés de part et d'autre du plan de joint (P) des deux plaquettes (2, 4, 102, 104), par coopération de formes entre lesdites gorges (6, 8, 106, 108) en regard.

5. Composant suivant la revendication 4, **caractérisé en ce que** lesdits canaux (12, 112) ont une section transversale de forme hexagonale.

6. Composant (228) suivant la revendication 1, **caractérisée en ce que** ladite couche opposée (202, 302) d'au moins l'une des première ou deuxième structure composite est réalisée en matériau métallique.

7. Composant suivant la revendication 6, **caractérisé en ce que** lesdits moyens de passage (210, 310) du fluide caloporteur débouchent sur la face distale de la couche métallique opposée (202, 302) audit circuit semi-conducteur de puissance (220).

8. Composant suivant la revendication 7, **caractérisé en ce que** lesdits moyens de passage comprennent au moins un canal (210, 310) s'étendant sur au moins une partie d'au moins une dimension de ladite couche métallique opposée (202, 302) d'au moins l'une des première ou deuxième structure composite.

9. Composant (28 ; 228) suivant l'une quelconque des revendications précédentes, **caractérisé en ce que** lesdits plots (23 ; 223) sont assujettis audit réseau plan (118 ; 306) de la deuxième structure composite (119 ; 308) par soudure d'au moins un bossage d'étain-plomb-argent (26 ; 226).

10. Composant suivant la revendication 9, **caractérisé en ce que** lesdits plots (23 ; 223) sont séparés du ou de chaque bossage (26 ; 226) par un revêtement adhérent au ou à chaque bossage, notamment un dépôt de titane-nickel-or (24).

## Claims

1. A power electronic component (28, 228) comprising a first heat transfer and electrical insulation composite structure (19; 208) supporting at least one power semiconductor circuit (20; 220) whose side opposite said first composite structure has connecting terminals (23; 223), said first composite structure (19; 208) including respective conductive or semiconductor layers (18; 206) adjacent said semiconductor circuit (20; 220) and conductive or semiconductor layers (10; 202) opposite said semiconductor circuit (20; 220), in which said connecting terminals (23; 223) are attached on the side opposite said first composite structure (19; 208) to a plane array (118; 306) of mutually insulated conductive members, said array being integrated into at least a second heat transfer and electrical insulation composite structure (119; 308) which includes a conductive or semiconductor layer (110; 302) opposite said semiconductor circuit, and in that the opposite layer (10, 110; 202, 302) of at least the first composite structure (19; 208) or the second composite structure (119; 308) comprises flow means (12, 112; 210, 310) for a heat transfer fluid.

2. A component (28) according to claim 1, **characterized in that** said layer (10, 110) opposite at least one of the first or second composite structures is made of a semiconductor material, in particular of silicon.

3. A component according to claim 2, **characterized in that** said semiconductor layer (10, 110) opposite at least one of the first or second composite structures comprises first and second wafers (2, 4, 102, 104) assembled together, at least one of the wafers having grooves (6, 8, 106, 108), and **in that** the heat transfer fluid flow means comprise through passages (12, 112) in said layer (10, 110) opposite at least one of the first or second composite structures, said passages being formed by co-operation of shapes between said wafers (2, 4, 102, 104).

4. A component according to claim 3, **characterized in that** said plates have respective series of grooves (6, 8) and the passages (12, 112) are formed by co-operation of shapes between said facing grooves (6, 8, 106, 108) on respective opposite sides of the junction plane (P) of the two wafers (2, 4, 102, 104).

5. A component according to claim 4, **characterized in that** said passages (12, 112) have a hexagonal cross-section.

6. A component (228) according to claim 1, **characterized in that** said layer (202, 302) opposite at least one of the first or second composite structures is made of a metallic material.

7. A component according to claim 6, **characterized in that** said heat transfer fluid flow means (210, 310) open onto the distal face of the metallic layer (202, 302) opposite said power semiconductor circuit (220).

8. A component according to claim 7, **characterized in that** said flow means comprise at least one passage (210, 310) extending over at least a portion of at least one dimension of said metallic layer (202, 302) opposite at least one of the first or second composite structures.

9. A component (28; 228) according to any preceding claim, **characterized in that** said terminals (23; 223) are attached to said plane array (118; 306) of the second composite structure (119; 308) by soldering at least one tin-lead-silver boss (26; 226).

10. A component according to claim 9, **characterized in that** said terminals (23; 223) are separated from the or each boss (26; 226) by a coating adhering to the or each boss, in particular a titanium-nickel-gold deposit (24).

## Patentansprüche

1. Elektronisches Leistungselement (28, 228), welches eine erste Verbundstruktur (19; 208) zur Wärmeübertragung und zur elektrischen Isolierung umfasst, wobei es wenigstens einen halbleitenden Leistungskreis (20; 220) unterstützt, dessen der ersten Verbundstruktur gegenüber liegende Seite mit Verbindungs-Kontaktstellen (23; 223) ausgestattet ist, wobei die erste Verbundstruktur (19; 208) zwei leitende oder halbleitende Schichten aufweist, jeweils angrenzend (18; 206) und gegenüber (10; 202) des halbleitenden Kreises (20; 220), bei welchem die Verbindungs-Kontaktstellen (23; 223) mit ihrer der ersten Verbundstruktur (19; 208) gegenüber liegenden Seite verbunden sind mit einem ebenen Netz (118; 306) von voneinander isolierten leitenden Elementen, wobei das Netz integriert ist in wenigstens eine zweite Verbundstruktur (119; 308) zur Wärmeübertragung und zur elektrischen Isolierung, welche eine dem halbleitenden Kreis gegenüber liegende leitende oder halbleitende Schicht (110; 302) aufweist, und bei welchem die gegenüber liegende Schicht (10, 110; 202, 302) von wenigstens einer der ersten (19; 208) oder zweiten (119; 308) Verbundstruktur Durchlassvorrichtungen (12, 112; 210, 310) für ein Kühlmittel aufweist.

2. Element (28) gemäß Anspruch 1, **dadurch gekennzeichnet, dass** ist die gegenüber liegende Schicht (10, 110) von wenigstens einer der ersten oder zweiten Verbundstruktur aus halbleitendem Material ist, insbesondere aus Silizium.

3. Element gemäß Anspruch 2, **dadurch gekennzeichnet, dass** die gegenüber liegende halbleitende Schicht (10, 110) von wenigstens einer der ersten oder zweiten Verbundstruktur erste und zweite miteinander verbundene Plättchen (2, 4, 102, 104) umfasst, wobei wenigstens eines der Plättchen mit Rillen (6, 8, 106, 108) ausgestattet ist, und dadurch, dass die Durchlassvorrichtungen für das Kühlmittel durchgehende Kanäle (12, 112) umfassen, die in der gegenüber liegenden Schicht (10, 110) von wenigstens einer der ersten oder zweiten Verbundstruktur eingerichtet sind, wobei die Kanäle durch Zusammenwirken der Formen zwischen den Plättchen (2, 4, 102, 104) realisiert sind.

4. Element gemäß Anspruch 3, **dadurch gekennzeichnet, dass** die Plättchen jeweils mit einer Reihe von Rillen (6, 8) ausgestattet sind und die Kanäle (12, 112) realisiert sind auf beiden Seiten der Verbindungsfläche (P) der zwei Plättchen (2, 4, 102, 104) durch Zusammenwirken der Formen zwischen den betreffenden Rillen (6, 8, 106, 108).

5. Element gemäß Anspruch 4, **dadurch gekennzeichnet, dass** die Kanäle (12, 112) einen hexagonalen Querschnitt haben.

6. Element (228) gemäß Anspruch 1, **dadurch gekennzeichnet, dass** die gegenüber liegende Schicht (202, 302) von wenigstens einer der ersten oder zweiten Verbundstruktur aus einem metallischen Werkstoff ist.

7. Element gemäß Anspruch 6, **dadurch gekennzeichnet, dass** die Durchlassvorrichtungen (210, 310) für das Kühlmittel zu dem fernen Ende der dem halbleitenden Leistungskreis (220) gegenüber liegenden Metallschicht (202, 302) führen.

8. Element gemäß Anspruch 7, **dadurch gekennzeichnet, dass** die Durchlassvorrichtungen wenigstens einen Kanal (210, 310) umfassen, der sich auf wenigstens einem Teil wenigstens einer Dimension der gegenüber liegenden metallischen Schicht (202, 302) von wenigstens einer der ersten oder zweiten Verbundstruktur erstreckt.

9. Element (28; 228) gemäß irgend einem der vorangegangenen Ansprüche, **dadurch gekennzeichnet, dass** die Kontaktstellen (23; 223) mit dem ebenen Netz (118; 306) der zweiten Verbundstruktur (119; 308) durch Löten wenigstens eines Buckels aus Zinn-Blei- Silber (26; 226) verbunden sind.

10. Element gemäß Anspruch 9, **dadurch gekennzeichnet, dass** die Kontaktstellen (23; 223) getrennt sind von dem oder von jedem Buckel (26; 226) durch einen an dem oder an jedem Buckel anhaftenden Überzug, insbesondere einer Abscheidung aus Titan- Nickel-Gold (24).
